# EUROPEAN PATENT APPLICATION

(11) **EP 1 233 488 A1**
(43) Date of publication of application: **21.08.2002**
(21) Application number: 01301352.9
(22) Date of filing: 16.02.2001
(51) Int. Cl.: H01S 5/068, H01S 5/0683

(54) **A light source**

(71) Applicant: Agilent Technologies, Inc. (a Delaware corporation), Palo Alto, CA 94303 (US)
(72) Inventor: Everett, Keith, Bury St. Edmunds, Suffolk IP33 2RB (GB)
(74) Representative: Coker, David Graeme

(57) **Abstract**

This invention relates to a light source (10) for producing a binary light signal of constant average power. The light source (10) includes a laser (12) and a current supply for supplying a current to the laser (12). The current has a slowly varying bias component (33) and a modulation component (35), each of which are independently controlled by the current supply so as to keep the average output power of the laser (12) constant when the temperature of the laser (12) changes during use. The current is controlled so as to keep the bias current just above the threshold current, the threshold current being inferred from previously obtained data values. An optical sensor is provided to monitor the average optical power output of the laser (12), and the modulation current is controlled by a feedback loop so as to keep the average optical output power constant.

## Description

This invention relates to a light source, in particular to a laser light source for producing a digital light signal of substantially constant average power.

Semiconductor lasers are commonly used in optical communication systems to produce a digital light signal having a low value and a high value. The drive current supplied to the laser normally consists of a constant or slowly varying bias component and a superposed modulation component, the modulation current having a zero value or a finite value depending on whether the digital signal is high or low.

A semiconductor laser will normally only laze in a stable fashion when the current applied to the laser is above a so-called threshold current. When the applied current is above the threshold current, the optical power emitted by the laser will normally rise linearly with the applied current.

One drawback of a semiconductor laser is that its temperature can change during operation through self heating or otherwise, with the result that the characteristics of the laser also change. In particular, with increasing laser temperature the threshold current will normally increase, and the slope of the emitted optical power as a function of applied current will normally decrease.

It is known to monitor the power output of a laser with a light detector and to use an algorithm having a feedback loop in order to determine the correct value of bias current required to keep the power output of the laser constant. In this algorithm, the value of the correct modulation current corresponding to a given bias current is obtained from a relationship based on a look up table containing experimentally determined bias current data and modulation current data, where each bias current data value is associated with a modulation current data value.

However, because the temperature dependent characteristics of a laser can vary significantly between lasers of different designs or even between lasers of the same design manufactured in different batches, the data in the look up table may need to be measured independently for different lasers.

In US4945541, there is described a method and apparatus for controlling the bias current of a laser by monitoring the light output of the laser. US5383208 describes a laser assembly where a temperature sensor is provided for measuring the temperature of the laser.

It is an object of the present invention to address the above issues.

According to the invention, there is provided a light source comprising: a laser operable to produce a binary optical data signal having a low value and a high value; a current driver circuit connected to the laser for supplying a current thereto, the current having a bias current component and a modulation current component; a control unit connected to the current driver for controlling independently of one another the modulation current component and the bias current component supplied to the laser; a temperature sensor for producing a temperature signal indicative of the temperature of the laser; and a light detector for producing a output power signal indicative of the average optical output power of the laser, characterised in that:
the control unit is responsive to the temperature signal, the control unit being operable to control the bias current component according to a predetermined functional relationship with the temperature signal, and,
the control unit is responsive to the output power signal, the control unit being operable to control the modulation current component on the basis of the received output power signal such that in use the average output power of the laser remains substantially constant.

The term average will be taken to mean an average over a period of time during which the high and low state of the binary optical data signal are averaged out.

Because in semiconductor lasers the variation of threshold current with temperature is more reproducable than the relationship between the modulation current component and the bias current, the predetermined relationship between the bias current component and the temperature need not be determined for each individual light source. The predetermined relationship may thus be determined experimentally from one laser, and used with light sources having the same or a similar type of laser.

Since a laser will normally have a threshold current below which the laser will not operate in a stable and/or effective manner, the predetermined functional relationship will preferably be such that in use the bias current component exceeds the threshold current, by a value denoted herein as delta (δ). When the binary light signal from the laser is at a low value, the current supplied to the laser will normally exceed the threshold current by the amount delta, so that the operation of the laser remains stable and/or effective.

The value of delta may be substantially constant and may be chosen such that the bias current supplied to the laser remains just above the threshold current, the value of delta being about 5% to 15% of the threshold current value.

To take into account a strong change in threshold current with temperature, the predetermined functional relationship will preferably be chosen such that the bias current varies with laser temperature so as to keep the optical power output of the laser when the optical data signal is low substantially constant. Since the modulation current is normally zero when the optical output power is low, controlling the modulation current so as to keep the average optical power output of the laser constant will result in the difference between the optical power output when the data signal is high and the optical power output when the data signal is low being kept constant.

Preferably, the control unit will have a control circuit with an input for applying an input signal and an output for producing an output signal in response to the input signal, the input-output characteristics of the control circuit being representative of the predetermined relationship.

Since the relationship between the threshold current and the laser temperature normally follows a smooth monotonically increasing curve, the predetermined relationship may be obtained from an analogue circuit, such as an amplifier circuit, the circuit having a current output for supplying a drive current to the laser.

Alternatively the control circuit may have a memory with a lookup table, the lookup table having data representative of a plurality of temperature signal values and data representative of a plurality of bias current values, wherein each temperature signal value is associated with a bias current value, and wherein the bias current value for each temperature signal value is chosen according to the predetermined relationship. The data may be generated by interpolating between data points experimentally obtained by measuring the threshold current of a laser at different temperatures.

In order to reduce the need to interpolate between experimentally obtained data points each time bias current data is required, a functional relationship capable of generating bias current data as a function of temperature data may be stored in the memory.

The control unit may have a microprocessor circuit connected to the light detector, the microprocessor circuit having a feedback algorithm for controlling the modulation current such that the average optical power emitted by the laser during use remains substantially constant. Since the modulation current can be controlled by the feedback algorithm independently from the bias current, keeping the average optical power output constant will be easier. Alternatively, the control unit may have an analogue feedback loop for controlling the modulation current.

The laser may be mounted on a chip carrier, in which case receiving/securing means may be provided on the chip carrier for receiving and securing the end of an optic fibre, such that light from the laser can be coupled into the optic fibre.

The temperature sensor and/or the light detector may be formed integrally with the laser. The temperature sensor may be a thermistor or a reversed-biased p-n junction.

The light detector will preferably be a photo diode. The light detector may have a response time that is sufficiently long to average out the high and low values of the optical data signal produced by the laser, or alternatively the average power may be obtained from by an averaging circuit.

The laser will preferably be a heterojunction laser formed from a III-V semiconductor wafer having a plurality of layers, such as layers of GaAs/AlGaAs, or layers of InP/InGaAs. The laser will preferably emit infra red light, but it may alternatively emit visible light.

The invention will now be further described by way of example with reference to the following drawings in which:
Figure 1 is a schematic representation of a light source with a current driver according to one embodiment of the invention;
Figure 2 is shows a trace of current produced by the current driver as a function of time;
Figure 3 shows a schematic trace of the optical power output of a laser as a function the applied current; and,
Figure 4 is a schematic representation of a light source with a current driver according to another embodiment of the invention.

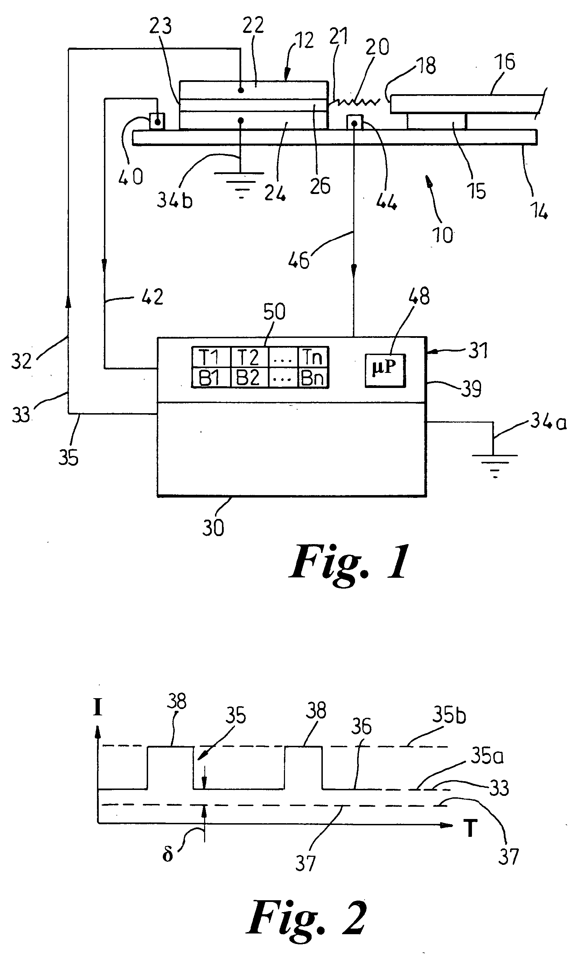

In Figure 1, there is shown a light source 10 in which a laser 12 is mounted on a chip carrier 14. An optic fibre 16 with an input 18 is mounted on the chip carrier 14 next to the laser, such that a light signal 20 produced by the laser 12 can enter the input 18 of the optic fibre 16.

The laser 12 is a semiconductor heterojunction laser having an upper layer forming an upper electrode 22, a lower layer forming a lower electrode 24, and an active layer 26 sandwiched between the upper and lower electrodes 22,24. (The terms upper and lower are used here with respect to the orientation of Figure 1). The laser has at one end a light output facet 21 through which the light signal 20 exits the laser. At another end, the laser has a mirrored surface 23 for reflecting light towards the output facet 21.

The upper electrode 22 is connected to a current driver 30 so that the current driver 30 can pass a current 32 through the laser 12. A return current path is provided to earth, the lower electrode 24 and the driver 30 each being connected to earth through earth connections 34a,34b provided on the current driver 30 and the lower electrode 24 respectively.

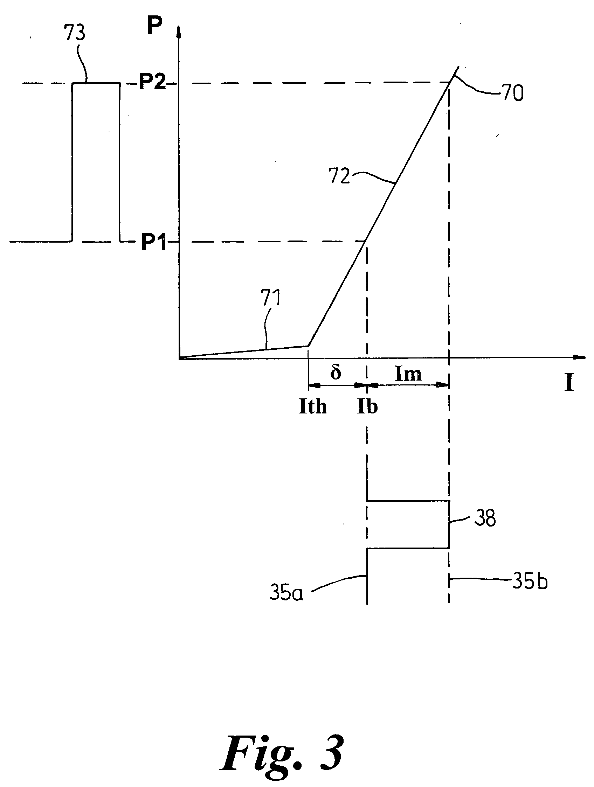

A typical trace 36 showing the current (I) produced by the current driver 30 as a function of time (T) is shown in Figure 2. The current 32 is the sum of a bias current 33 (Ib) and a modulation current (Im) 35, the modulation current having a low value 35a or a high value 35b, changing in a step wise fashion between the low value 35a and the high value 35b so as to form one or more pulses 38 superposed on the bias current 33, which changes slowly as compared to the modulation current 35. The bias current 33 is at a level that exceeds the threshold current 37 (Ith) of the laser 12 by an amount (δ). The value of δ will preferably be a function of temperature such that the output power of the laser (12) when the optical signal is low (P1 in Figure 3) will not change with temperature. To control the current 32, and in particular to control the bias current 33 and the modulation current 35 independently of one another, the current driver 30 has a control unit 31 incorporated therewith.

Figure 3 shows schematically a trace 70 for the optical power output (P) of a typical laser as a function of the current (I) being passed through the laser. In a lower portion 71 of the trace 70, below the threshold current, the laser is unstable and the power output generally small. In an active portion 72 of the trace 70, when the current through the laser is above the threshold current, the optical power rises linearly with the current. A current pulse 38 having a low value 35a and a high value 35b is indicated schematically on the current axis, the current pulse resulting in an optical output pulse 73 having a low value P1 and a high value P2 corresponding respectively to the low and high current values 35a,35b.

The light source has a temperature sensor 40 mounted on the chip carrier 14. The temperature sensor 40 is in thermal contact with the laser 12 so that a temperature signal 42 produced by the temperature sensor 40 is representative of the temperature of the laser 12.

A light detector 44 is mounted on the chip carrier 14 in order to monitor the optical output power of the laser 12, the light detector 44 being mounted such that a portion of the light signal 20 fed into the fibre 16 is incident on the detector 44. The light detector is shown close to the output 21 of the laser, but the light detector may be situated so as to receive light from the back mirrored surface 23 of the laser, the back mirrored surface 23 being partially reflecting. The light detector 44 produces an electrical output power signal 46 that is representative of the average optical output power of the laser 12 i.e. (P1+P2)/2. Since the value of P1 is kept constant as the temperature of the laser (12) changes, the amount by which the optical power is modulated (i.e. P2-P1) will also remain constant.

The temperature sensor 40 and the light detector 44 are each electrically connected to the control unit 31, such that the control unit 31 receives the temperature signal 42 and the output power signal 46. The control unit 31 has an electronic circuit 39 for controlling the current 32 supplied to the laser 12 as a function of the received temperature signal 42 and the output power signal 46. The bias current 33 is controlled on the basis of temperature signal 42, so that when the threshold current 37 changes due to a change in the laser temperature, the bias current changes also.

The electronic circuit 39 in the control unit 31 has a memory 50, the memory containing temperature data T1,T2..Tn and bias current data B1,B2..Bn, a bias data value being associated with each temperature data value. The electronic circuit 39 has a microprocessor (µP) 48 for selecting the temperature signal value associated with the temperature signal 42 produced by the temperature sensor 40. The temperature data and bias current data will have been chosen such that for each temperature signal 40, the bias current 33 is greater by a predetermined amount δ than the threshold current 37 of the laser 12.

The temperature data and bias current data will have been determined experimentally by carrying out measurement on a similar laser to the laser 12 of the light source 1, in order to establish how the threshold current 37 changes with temperature.

The microprocessor 48 is programmed with an algorithm having a feedback loop in order to control the modulation current 35 according to the output power signal 46 received from the light detector 44. The modulation current 35 is controlled such that when the slope of the active portion 72 of the trace 70 changes with temperature, the modulation current 35 changes, either so as to keep the difference between P1 and P2 constant, or to keep the average power (given by the average of P1 and P2) constant.

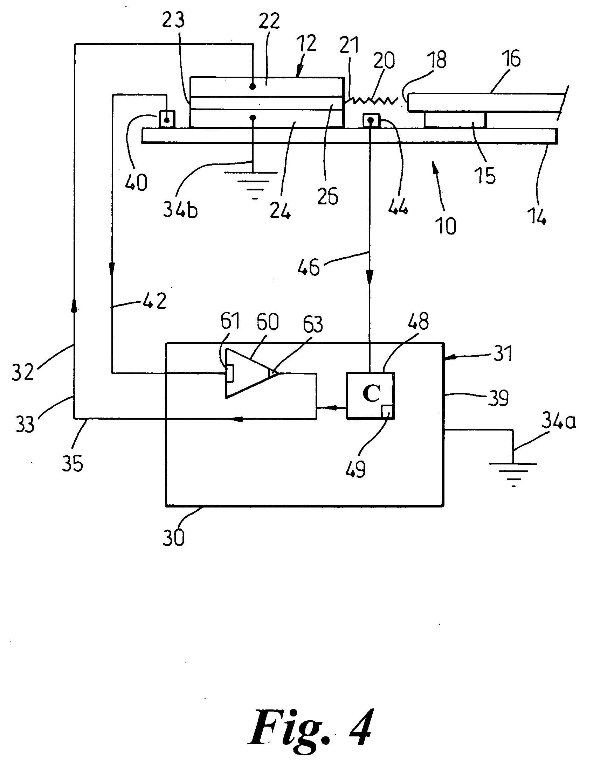

Figure 4 shows a light source 10 with an current driver 30 according to alternative embodiment. In this embodiment, an amplifier circuit 60 is shown having an input 61 and a current output 63. The input 61 is connected to the temperature sensor 40 for receiving the temperature signal 42, and the current output 63 is connected to the upper electrode 22 of the laser 12, for passing a bias current 33 through the laser 12. The relationship between the input 61 and the output 63 of the amplifier is chosen such that the bias current 33 supplied to the laser 12 exceeds the laser threshold current 37 by a predetermined amount.

The modulation current 35 is provided by an analogue feedback control loop circuit 48 (C) having a current amplifier 49, the circuit 48 being connected the output power sensor 44 in order to control the modulation current 35 on the basis of the output power signal 46 such that the output power of the laser 12 is kept substantially constant.

As it will be appreciated from the above description, the present invention provides a simple way of taking into account the temperature changes in a laser in order to keep the optical output power of the laser constant.

## Claims

1. A light source (10) comprising: a laser (12) operable to produce a binary optical data signal (20) having a low value and a high value; a current driver (30) connected to the laser (12) for supplying a current thereto, the current having a bias current component (33) and a modulation current component (35); a control unit (31) connected to the current driver (30) for controlling independently of one another the modulation current component (35) and the bias current component (33); a temperature sensor (40) for producing a temperature signal (42) indicative of the temperature of the laser (12); and a light detector (44) for producing a output power signal (46) indicative of the average optical output power of the laser (12), **characterised in that**:
the control unit (31) is responsive to the temperature signal (42), the control unit (31) being operable to control the bias current component (33) according to a predetermined functional relationship with the temperature signal (42), and,
the control unit (31) is responsive to the output power signal (46), the control unit (31) being operable to control the modulation current component (35) on the basis of the received output power signal (46) such that in use the average output power of the laser (12) remains substantially constant.

2. A light source (10) as claimed in Claim 1, wherein the laser (12) has a threshold current (37) associated therewith, and wherein the predetermined functional relationship is such that in use the bias current component (33) exceeds the threshold current.

3. A light source (10) as claimed in Claim 2, wherein the functional relationship is chosen such that bias current varies with laser temperature so as to keep the optical power output of the laser when the optical data signal is low substantially constant.

4. A light source (10) as claimed in any preceding claim, wherein the control unit (31) has a control circuit with an input (61) for receiving an input signal and an output (63) for producing an output signal in response to the input signal, the input-output characteristics of the control circuit being representative of the predetermined relationship.

5. A light source (10) as claimed in any preceding claim wherein the control unit (31) has a memory with a lookup table (50), the lookup table (50) having data representative of a plurality of temperature signal (42) values and data representative of a plurality of bias current values, wherein each temperature signal (42) value is associated with a bias current value, and wherein the bias current value for each temperature signal (42) value is chosen according to the predetermined relationship.

6. A light source (10) as claimed in Claim 4, wherein the control circuit (31) has an analogue circuit (60) and wherein the output is a current output for supplying a drive current to the laser (12).

7. A light source (10) as claimed in Claim 4, wherein the control circuit (31) has a memory for storing a functional relationship which can generate bias current data as a function of temperature data.

8. A light source (10) as claimed in any preceding claim, wherein the laser (12) is mounted on a chip carrier (14), and receiving/securing means (15) are provided on the chip carrier for receiving and securing the end of an optic fibre, such that light from the laser (12) can be coupled into the optic fibre.

9. A light source (10) as claimed in any preceding claim, wherein the temperature sensor (40) and/or the light detector (44) is/are formed integrally with the laser (12).

10. A light source (10) as claimed in any preceding claim, wherein the control unit (31) has a microprocessor circuit (48) connected to the light detector (44), the microprocessor circuit (48) having a feedback algorithm for controlling the modulation current (35) such that the average optical power emitted by the laser (12) during use remains substantially constant.

11. A light source (10) as claimed in any of claims 1 to 9, wherein the control unit (31) has an analogue feedback loop for controlling the modulation current.

12. A light source (10) as claimed in any preceding claim, wherein the light detector (44) has a response time that is sufficiently long to average out the high and low values of the optical data signal produced by the laser.
